# EUROPEAN PATENT SPECIFICATION

(11) **EP 2 744 925 B1**
(45) Date of publication and mention of the grant of the patent: **03.02.2016**
(21) Application number: 12784056.9
(22) Date of filing: 14.08.2012
(51) Int. Cl.: C23C 16/458, C23C 16/509, H01L 31/00, C23C 16/455, H01L 21/205, H01J 37/32

(54) **REACTION CHAMBER FOR DEPOSITION OF A SEMICONDUCTOR LAYER ON THE PLURALITY SUBSTRATES IN BATCHES**
REAKTIONSKAMMER ZUR ABSCHEIDUNG EINER HALBLEITERSCHICHT AUF MEHREREN SUBSTRATEN IM CHARGENBETRIEB
CHAMBRE DE RÉACTION POUR LE DÉPÔT D'UNE COUCHE DE SEMI-CONDUCTEUR SUR UNE PLURALITÉ DE SUBSTRATS DANS DES LOTS

(30) Priority: 15.08.2011 HU P1100437
(43) Date of publication of application: 25.06.2014
(73) Proprietor: Ecosolifer AG, 6062 Sarnen (CH)
(72) Inventor: VADADI, Zsolt, H-1022 Budapest (HU); STRAUSZ, Tamás, H-2040 Budaörs (HU); NÉMETH, Péter, H-9700 Szombathely (HU)
(74) Representative: Lantos, Mihaly
(86) International application number: PCT/HU2012/000074
(87) International publication number: WO 2013/024315

(56) References cited:
- WO-A1-99/28528
- CN-A- 101 626 049
- HU-B1- 227 809
- US-A1- 2009 230 019

## Description

The present invention refers to a reaction chamber for deposition of a semiconductor layer or layer structure on a surface of a plurality of substrates in substrate batches with improved loading / unloading system.

Such reaction chambers comprise a body with an inner volume and an upper lid and closing bottom lid, in the inner volume rectangular plate-like substrates are arranged in a spaced apart relationship with each other and electrodes suitable for providing high-frequency electromagnetic field in order to deposit a thin material layer are disposed between the substrates; each electrode is disposed in a spaced-apart relationship adjacent to the surface of the substrate not to be deposited; and each space extending between the surfaces to be deposited forms a flow channel making available the laminar flow of reaction gases between two opposite sides of the chamber; the opposite electrodes are connected to a high-frequency generator and the closed inner volume of the chamber is provided with a heating element.

The most common types of so the called batch-processing equipments-which are applicable to simultaneously deposit various layers onto a plurality of large substrates - are known from documents CN 101626049 and P0700164.

Document CN 101626049 discloses a method for manufacturing a film solar cell, which comprises the steps of mounting substrates on respective surfaces of a plurality electrode plates in a reaction chamber, the electrodes supporting the substrates are introduced one by one into a CVD thin layer deposition chamber, then the electrodes supporting the substrates are each connected to a respective RF generator supplying RF power, subsequently a reaction gas of predetermined composition is introduced into the chamber, and RF plasma discharge is formed in the chamber in order to produce various thin layers.

Hungarian patent application No. P0700164 discloses an apparatus which has an inner reaction volume, in the reaction volume a plurality of parallel, planar, spaced apart electrode pairs are arranged, and the planar electrodes on their opposite surfaces support a plurality of substrates envisaged to be subject of layer deposition. During normal operation of this apparatus the substrates can be loaded only in the unloaded state of the electrodes from the chamber, and substrates must be placed onto the electrode surfaces one by one outside the reaction chamber, and the electrodes and substrates are loaded together again into the reaction chamber. The loading of electrodes is done individually or in electrode batches. WO 99/28528 discloses an apparatus for the deposition on substrate batches, wherein electrodes are placed in between two substrates. US 2009/0230019 shows substrate cassettes having electrode arrays, which are placed into slots.

In the solutions proposed in the prior art during loading and unloading of the substrates the electrodes must also be removed. In every loading/unloading step the electrodes are connected to the plugs in the inner volume of the chamber manually. Such one by one loading increases the idle periods of the apparatus and the frequent connection and disconnection of electrodes and plugs in every loading/unloading cycle is a source of failure. These operations are not susceptible to automation.

Object of the present invention is to provide an improved substrate loading system for which the idle time is lower compared to prior art methods and which loading system can be automated.

Further object of the present invention is to provide an improved substrate loading system in which loading and unloading is performed along one single spatial direction of the chamber, and other devices corresponding to other functions of the chamber (such as gas distribution) are arranged along different spatial directions, thus different functions of the chamber and devices performing these different functions are geometrically separated from each other.

According to the invention the above objects are achieved with an improved reaction chamber as described in claim 1.

In the following description an advantageous embodiment of the invention will be described in detail with reference to the attached drawing, wherein in
Fig. 1 a reaction chamber supported by a structure of metal profiles is shown in perspective view,
Fig. 2 is a top view of the supporting frames which are placed adjacent to each other and in which the substrates will be inserted, in
Fig. 3 a loading container containing a plurality of adjacent supporting frames is shown in perspective top view, in
Fig. 4 detail "A" of Fig. 3 can be seen in an enlarged view, wherein three adjacent supporting frame is shown in perspective view, and
Fig. 5 is a perspective, partially cut-out sectional view of the reaction chamber, wherein the chamber is rotated by -90° with respect to the view of Fig. 1.

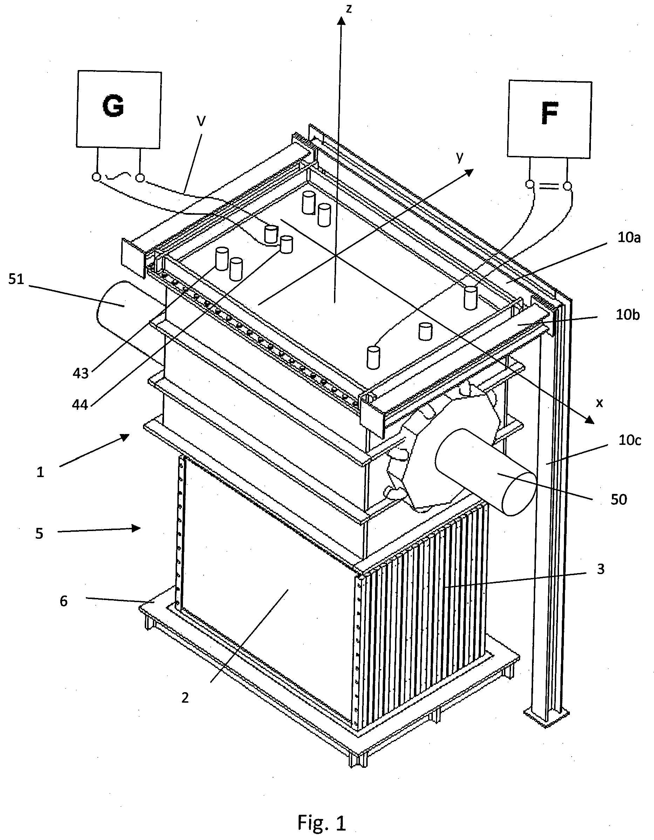

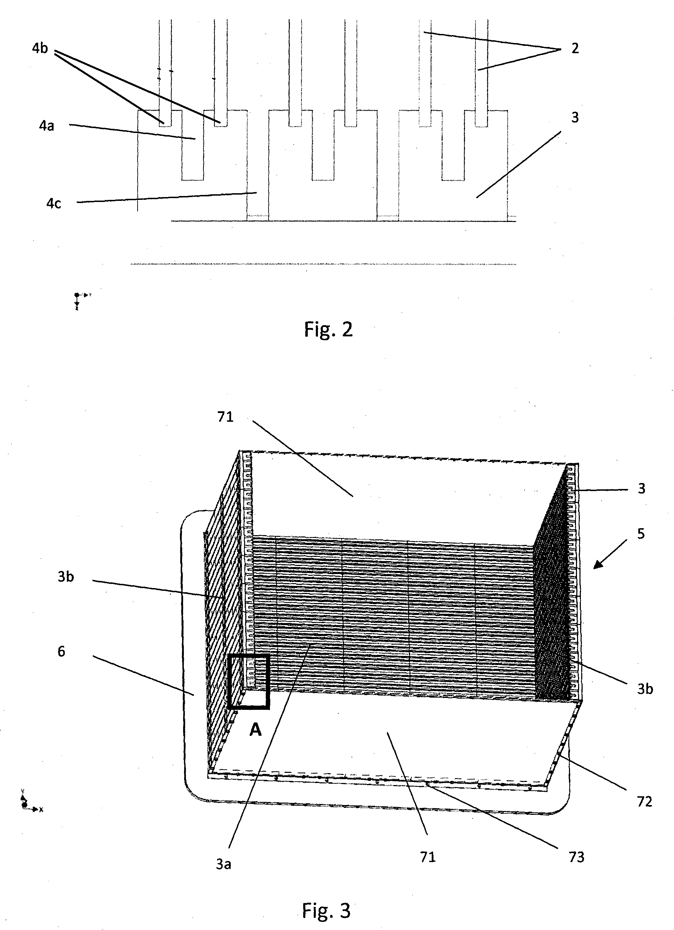

The reaction chamber 1 in fig. 1 has a framework made of 10a, 10b, 10c consoles. The 10a, 10b, 10c consoles are perpendicular to each other and are arranged along x, y and z directions, respectively. Dimensions and materials of the 10a, 10b, 10c consoles are selected so as to have sufficiently large load bearing capacity for holding the reaction chamber 1 which is very heavy in its loaded state. In the drawing it is not shown, but the walls provide an air tight sealing of the reaction chamber 1 and during operation in the inside of the reaction chamber 1 a background pressure lower than the atmospheric pressure is present, which is necessary for the reaction. The inner volume of the reaction chamber 1 comprises a structure of parallel, spaced apart plates. Said inner structure is partially made up by substrates 2, here substantially rectangular glass plates - depicted in the enlarged partial view of Fig. 2 - and on one surface of the glass plates a semiconductor thin layer or thin layer structure is to be deposited in the reaction chamber 1, for example by a CVD process and finally, on said plates photovoltaic devices are formed. The thin layer structure may comprise layers not made of semiconductor materials; such layers are built in a separate deposition step in the same or in a different reaction chamber 1. Such deposition step may comprise e.g. the formation of a slightly conducting layer on top of the active surface of the glass substrates 2. In Fig. 1 it is schematically shown that the substrates 2 are surrounded and supported along their side edges and along their bottom by supporting frames 3. These frames form an interconnected supporting structure, this structure being attached to the bottom closing lid 6 of the reaction chamber 1. This whole mechanical structure in the form of a loading container 5 can be loaded in a properly guided manner into the reaction chamber 1 from the bottom, upwards along the z direction and when the layers are deposited the loading container can be unloaded. In Fig. 1 the whole structure is shown at the beginning of the loading step.

In the same figure there is shown the upper lid of the reaction chamber 1 with connectors V to which a heater F and a generator G is connected through wiring. The heater F is connected by means of connecting elements which also have a function of 43 threaded rods. A further connecting element 44 protruding from the upper lid of the reaction chamber 1 is used for the connection of the radio frequency generator G. On the upper lid of the reaction chamber 1 a number of such threaded rods 43 and connecting elements 44 are arranged in a manner to be described later in detail. In this diagrammatic view only three of them are shown in order to schematically represent the connection of the heater F and the generator G.

On the two opposite sidewalls of the reaction chamber 1 perpendicular to the y direction an inlet channel 50 for introducing the reaction gases and an outlet channel 51 for removing the reaction byproducts are arranged. Between the inlet channel 50 and the outlet channel 51 the direction of gas flow is parallel to the plane of substrates 2.

Fig. 2 is a top view of an enlarged section of the supporting frames 3 in which the substrates 2 are inserted. In the inventive batch-processing equipment, which is capable to simultaneously handle a plurality of large 2 substrates, a number of supporting frames 3 are placed adjacent to each other - in Fig. 2 three of them is shown. Each supporting frame 3 comprises three recesses: two recesses 4b of identical shape and thickness, and a third recess 4a formed between said two recesses 4b and being deeper and having larger width than said two recesses 4b. Recesses 4b have a dimension so that substrates 2 /e.g. glass plates used as substrates/ can snugly fit into them. Thickness of the substrates 2 is between about 0.5 mm and 5 mm, preferably 2 mm, thus the width of said two recesses 4b is also in this range. The actual width of recess 4b must be determined in advance, e.g. by etching, according to the actual size of substrates 2 to be used in the apparatus. The supporting frames 3 are made of an electrically insulating and mechanically rigid material, which also have sufficient resistance against compositions participating in the reaction to be carried out in the inner volume of the reaction chamber 1 and can also withstand high pressure and high temperature existing in the chamber. The supporting frames 3 are placed adjacent to each other in a periodic structure. For example in Fig. 2 going from left to right first comes a recess 4b which belongs to a first supporting frame 3, then recess 4a and again recess 4b belonging to the same frame 3 is seen, then we see a very narrow gap 4c dividing the first supporting frame 3 from the next adjacent supporting frame 3, then recess 4b, recess 4a and again recess 4b of the adjacent supporting frame 3 is seen etc.

In Fig. 3 the loading container 5 to be introduced into the reaction chamber 1 is shown in elevational perspective view from above and for the sake of better visibility some details are hidden. For example the substrates 2 which are supported in the recesses 4b are not seen. Each supporting frame 3 consists of two lateral frame parts 3b and a bottom frame part 3a which together are joined to a single, rigid mechanical structure. The supporting frame 3 is open from above, thus it supports the substrates 2 only on the bottom and from the sides. This is particularly important, since the substrates 2 are inserted into the recesses 4b of the supporting frame 3 from the top which is kept open. In the loading container 5 built up by a plurality of supporting frames 3 the following periodic structure is seen - using reference signs of Fig. 2: a recess 4b then a recess 4a and again recess 4b of the same supporting frame 3, then a small gap 4c between two adjacent supporting frames 3 and in the loading container 5 this period is repeated in a finite number. The number of supporting frames 3 is chosen on the basis of practical aspects, their number is preferably 25 to 50. Here the number of substrates 2 to be loaded is twice the number of frames. Each supporting frame 3 in the loading container 5 has the same dimensions. The supporting frames 3 and their recesses can firmly support the large glass plate substrates 2 during loading and unloading operations and the reaction. Lateral frame parts 3b of each supporting frame 3 are slightly longer than the height of the substrates 2; whereas the bottom frame parts 3a of the supporting frames 3 are slightly longer than the width of substrates 2. Size of the substrates 2 corresponds to the size foreseen for the devices to be fabricated and can be set to different values. The most preferred range is between 50 cm x 75 cm and 150 cm x 200 cm; a very frequently used dimension is 100 cm x 150 cm.

The supporting frames 3 which comprise more frame parts are made of an electrically insulating material. Such materials can be chosen among plastics or ceramics, e.g. alumina or Teflon, but for this purpose other electrically insulating materials with high mechanical hardness can also be used i.e. glass, minerals, composite materials etc. It is not excluded to make the supporting frames 3 of metal, however, in this case the metal surface must be covered by an insulation layer.

The bottom of the loading container 5 is fastened to the bottom closing lid 6 which is disposed below the bottom frame parts 3a and is attached to the supporting frames 3 and has a broad rim portion. In order to make the structure more rigid the two outermost supporting frames 3 limiting the loading container 5 in the lateral direction are connected to fastening plates 71 and on the rear side or in the middle of the vertically oriented lateral frame parts 3b apertures are provided through which threaded bolts 72 are guided in the transversal direction, the ends of the bolts are fastened by means of nuts, and these bolts keep all lateral frame parts 3b together. Similarly, on the bottom the bottom frame parts 3a are kept together by threaded bolts 73 and corresponding nuts. The whole structure is held together on the bottom by the bottom closing lid 6.

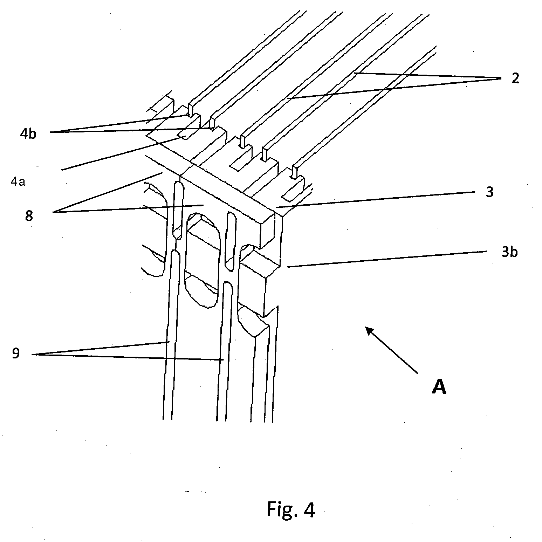

In Fig. 4 detail "A" of Fig. 3 is shown in enlarged perspective view, wherein the substrates 2 which were invisible in Fig. 3 are also depicted. Three supporting frames 3 are arranged next to each other, and a possible connection of the supporting frames 3 is also exemplified. To each lateral frame part 3b of the supporting frames 3 ribs 8 are attached by means of releasable connecting means, e.g. bolts. Each rib 8 is responsible for holding together three supporting frames 3. The ribs 8 are provided with openings, e.g. by grooves 9 which are positioned so as to overlap with the gaps 4c between the adjacent supporting frames 3 when the ribs 8 are mounted onto the frames. Thanks to this arrangement during the CVD process the gases entering the reaction chamber 1 must flow through the grooves 9 of the ribs 8 and subsequently through the gaps 4c between adjacent supporting frames 3 and by flowing further towards the inside of the loading container the reaction gases enter into the volumes 20 extending along the substrate 2 surfaces to be deposited. Thus, these volumes 20 are used as reaction volumes, which serve for plasma generation and serve as a place of chemical reactions.

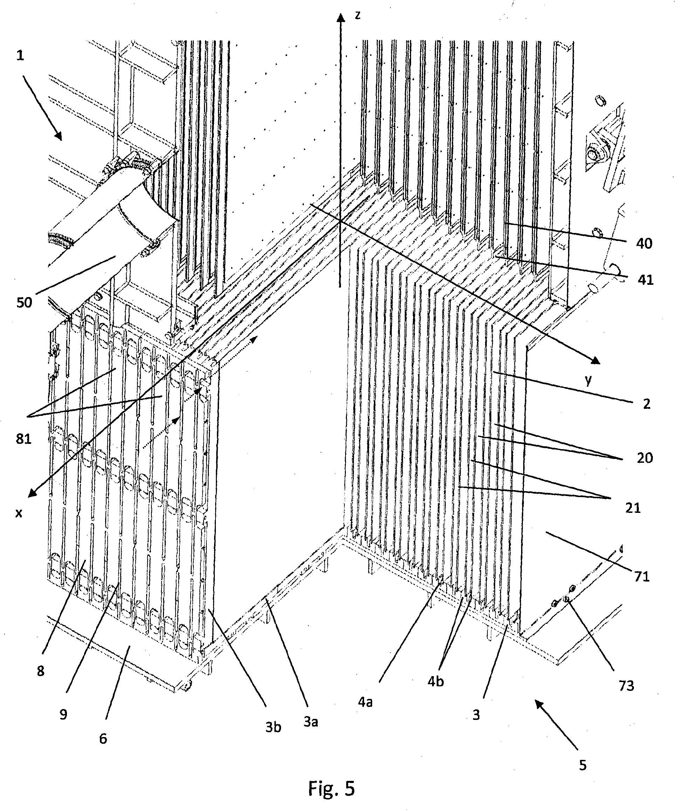

In Fig. 5 the reaction chamber 1 is shown in a partially cut-out, perspective view, with the loading container 5 being in an intermediate phase of loading. The cut-out is made such that one quarter of the chamber is removed at a one corner of the reaction chamber 1 and the important elements inside are also visible. The reaction chamber 1 is rotated by -90° degree with respect to the view of Fig. 3, which can be observed from the different orientation of the substrates 2. In order to provide better visibility of the change of orientation x, y and z directions are also shown. The x, y, z directions form here as well a right-handed coordinate system, however the x and y axes point to other directions, rotated by -90° degree.

From the upper part of the reaction chamber 1 planar, rectangular, spaced apart, equidistant and parallel electrodes 40 are suspended towards the bottom and during the upwards movement of the frames each electrode along its width reaches into recesses 4a of the supporting frames 3 and the recesses support and guide the electrodes. In this manner an interpositioned, comb-shaped plate structure is formed, in which two substrates 2 always enclose an electrode 40, and on the side of the substrates 2 opposite to the electrodes 40 a volume suitable for gas flow is formed. Due to this advantageous arrangement during introduction into the reaction chamber 1 the substrates 2 line up in a comb-shaped manner between the electrodes 40 which are fixed in their positions in the chamber 1. Between the substrates 2 volume 20 and volume 21 are alternating. The volumes 20 are reaction volumes for reaction gases. Into volumes 21 the electrodes 40 are inserted. Loading is completed when the substrates 2 are all the way slid into the reaction chamber 1 with the electrodes 40 interpositioned between them. In this position the flattened part 41 (rims) of each electrode 40 fits into recess 4a of the respective supporting frame 3 and is firmly supported and guided therein. In each recess 4a the respective electrode 40 is inserted with a small play such that sufficiently large space is left for deformations due to thermal dilatation. Even further, electrode 40 is inserted with a small play into volume 21 between two substrates 2 such that sufficiently large space is left between the substrate 2 and the electrode 40 for deformation due to thermal dilatation. As it has been shown earlier recess 4a is deeper than the two recesses 4b encompassing it. Consequently, in a completely loaded position the electrodes 40 slightly reach over the surfaces of the substrates 2. In this manner we achieve that in the region of the substrate 2 surfaces inhomogeneous plasma conditions and related fluctuations and transient processes of the deposition conditions are suppressed and the quality and thickness of the deposited layer is homogeneous.

Thus, in the fully loaded position the electrodes 40 and the substrates 2 which are completely slid between them form a sandwich structure in which e.g. the following come periodically in a consecutive order: a substrate 2 placed into a recess 4b corresponding to a first supporting frame 3, an electrode 40 placed into recess 4a, again a substrate 2 placed into recess 4b, then the volume 20 between substrates 2 of two adjacent supporting frames 3 (which volume is eventually a broadened extension of the gap 4c between two adjacent supporting frames 3 and extends further between the substrates 2), then a subsequent substrate 2 inserted into recess 4b corresponding to a supporting frame 3 next to the first one, an electrode 40 inserted into recess 4a and again a substrate 2 inserted into recess 4b etc. In the loading container 5 introduced into the reaction chamber 1 this periodic structure is repeated in finite number.

It is observable mainly from Fig. 1 that electrode 40 comprises two threaded bolts 43 protruding from the upper part of the electrode 40. Said threaded bolts 43 fit into holes provided in the upper lid of the reaction chamber 1 and said threaded bolts 43 are fastened to the lid of the reaction chamber 1 by releasable connecting elements, e.g. by screws. The threaded bolts 43 serve - beyond fastening - as electric connectors for the electric power supply of the heater F cable to be described in detail later. At the upper edge of the electrode 40 a further connecting element 44 is disposed for connecting the RF generator G. The suspension is realized by means of releasable connection, however, during normal operation conditions e.g. between two CVD cycles these connections do not need to be disconnected. This means that the heating F cables and the connections of the RF generator G do not need to be disconnected, which makes the implementation of the CVD process easier, more reliable and as a result, productivity is improved.

Also in Fig. 5 it is shown that the loading container 5 along its bottom side is fastened to the bottom closing lid 6. The outermost supporting frames 3 limiting the loading container 5 in the lateral direction are connected to fastening plates 71 and releasable fastening elements, e.g. screws which firmly hold in place the fastening plate 71 with respect to the closing lid 6.

Ribs 8 are attached to the lateral frame parts 3b of the supporting frames 3. One single rib 8 accounts for connecting three adjacent supporting frames 3. In this figure the boarder lines 81 between the ribs are visible. Further, between the grooves 9 of the ribs 8, in the gaps 4c between the supporting frames 3 and in the volumes 20 between two substrates 2 along the path marked by dashed arrows a free gas flow channel is formed. By this arrangement during the CVD process gases can flow through the reaction chamber 1.

A main feature of the reaction chamber 1 is that the electrodes 40 are suspended from the inner side of the upper part of the reaction chamber 1 - using directions of Fig. 5. The suspension is effected by releasable connection, however during normal operation conditions, e.g. between two CVD reaction cycles, these connections need not to be disconnected. Disconnection of the electrodes 40 might be necessary for example in case of maintenance works. This means that the heating F cables connected to the electrodes 40 and the connections of the radio frequency generator G need not to be disconnected, which makes the implementation of the CVD process easier, more reliable and as a result productivity is improved.

A further important feature of the present invention is that the plurality of electrodes 40 is aligned parallel to the plurality of substrates 2 and perpendicular to the plane of the bottom closing lid 6, and during loading the electrodes 40 and substrates 2 line up with each other in a comb-shaped manner, and there is no need for manually mounting the substrates 2 one by one onto the surface of electrodes 40. According to the invention the connections of the generator G and the heater F, the gas distribution system for providing a process gas flow - gas flow channel is denoted by reference number 50 in Fig. 5 - and the bottom closing lid 6 are each arranged according to different x, y, z orthogonal directions of the reaction chamber 1 on its six faces. Thus, different functions of the reaction chamber 1 are separated according to different spatial directions.

Using x, y and z directions according to Fig. 5 the most preferred embodiment is where the loading container 5 and the closing bottom 6 attached thereto are moved along the z axis. Further, the connections coupling the electrodes 40 to the heater F and the generator G are also realized along the z axis, e.g. on the upper side of the chamber opposite to the bottom closing lid 6. In this embodiment the gas flow channel is formed in the y direction and the introduction of reaction gases and draining of reaction byproducts is realized in the y direction on two opposite faces of the chamber. In this manner it is advantageously achieved that the loading/unloading direction of the chamber 1 is orthogonal to the gas flow direction. By implementing different functions in different directions various elements of the reaction chamber 1 and processes carried out by said various elements are well separated from each other.

It is also conceivable to have an alternative geometrical arrangement e.g. in which the loading container 5 and the closing bottom 6 attached thereto are moved along the vertical z axis, the connections coupling the electrodes 40 to the heater F and the generator G are realized on a side along the x axis and the gas flow channel is formed in the y direction so that the introduction of reaction gases and draining of reaction byproducts is realized in the y direction on two opposite faces of the chamber.

## Claims

1. Reaction chamber (1) for the deposition of a semiconductor layer or layer structure on a surface of each one of a plurality of substrates (2) that have rectangular plate-like shapes and can be inserted in said reaction chamber (1), comprising a chamber body with an inner volume, an upper lid and a closing bottom lid (6) for said chamber body, in operation the substrates are inserted and arranged in the inner volume of the chamber body in a spaced apart relationship with each other, respective electrodes (40) are arranged between respective pairs of the substrates (2) for providing high-frequency electromagnetic field to deposit a thin material layer on said surfaces under the effect of reaction gases; the respective spaces formed between said substrate (2) surfaces to be deposited act as flow channels providing a laminar flow of the reaction gases between two opposite sides of the chamber body, respective opposite ones of said electrodes (40) are connected to different connectors (V) of a high-frequency generator (G) and the closed inner volume of the chamber (1) is provided with a heater (F), **characterized in that** the closing bottom lid (6) of the reaction chamber (1) can be opened in vertical up/down direction, and the lid comprises a plurality of supporting frames (3) for surrounding and holding the substrates (2) along their bottom and two side edges, said supporting frames (3) are arranged at a distance to each other, and the supporting frames (3) are each provided with a periodic repetition of three spaced recesses (4a, 4b) provided along their entire length for receiving and holding said bottom and side edges of the substrates (2) and for the edges of the electrodes (40), wherein in each of said spaced triplet of said recesses (4a and 4b) the two outer recesses (4b) receive the edges of an associated substrate (2) and the central recess (4a) receives the edges of an associated electrode (40) so that the surfaces of said substrates (2) that are spaced from and face towards said electrode (40) are the non-deposited substrate surfaces, and the opposite surfaces of the substrates (2) are said deposited surfaces, and in operation said internal volume of said chamber body is substantially defined by the spacing distances between said recesses (4a, 4b) of the frames (3) and the distances between the frames (4c), and the distance (4c) between adjacent supporting frames (3) determines the width of said gas flow channels, and the bottom lid (6) together with the supporting frames (3) and the substrates (2) are inserted into said recesses (4b) forming a mechanically integrated body, which body in the form of a loading container (5) can be loaded into, fixed in and unloaded from the inner volume of the reaction chamber (1), and the electrodes (40) are attached to and are suspended from the upper lid, and during loading of the loading container (5) in said chamber the side and bottom edges of the electrodes are guided and supported by the central recesses (4a) of the supporting frames (3).

2. The reaction chamber according to claim 1, **characterized in that** the supporting frames (3) are made of an electrically insulating, heat resistant material, and their outer parts are mechanically connected to each-other so that they form a solid, integrated body.

3. The reaction chamber according to claim 1, **characterized in that** the recesses (4b) of the supporting frames (3) suitable for receiving the substrates (2) have smaller depth than the recesses (4a) suitable for receiving the electrodes (40).

4. The reaction chamber according to claim 1, **characterized in that** the vertical supporting frames (3b) are interconnected by respective structures at each side which are provided with openings (9) aligned with said gas flow channels to allow insertion and removal of the reaction gases from said channels.

5. The reaction chamber according to claim 1, **characterized in that** the chamber has a rectangular shape, wherein the gas flow channels open to two opposite side walls which are each perpendicular to the upper lid and the closing bottom lid (6), respectively, and in one of the side walls a gas inlet channel (50) and in the opposite side wall a gas outlet channel (51) is formed.

6. The reaction chamber according to claim 1, **characterized in that** the supporting frames (3) which hold the substrates (2) from the bottom and along their side edges are assembled from three interconnected supporting frame (3) parts.

7. The reaction chamber according to claim 1, **characterized in that** the electrical connection between the electrodes (40) and the high-frequency generator (G) can be maintained during loading and unloading of the loading container (5).

8. The reaction chamber according to claim 1, **characterized in that** each of the electrodes (40) is built up by two spaced apart plates which define a closed inner volume in which heating elements are disposed, and the electrodes (40) also fulfill the function of a heating element.

## Patentansprüche

1. Reaktionskammer (1) zur Abscheidung einer Halbleiterschicht oder Schichtstruktur auf einer Oberfläche jedes einer Vielzahl von Substraten (2), die eine rechteckige plattenähnliche Form haben und in die Reaktionskammer (1) eingeführt werden können, umfassend einen Kammerkörper mit einem Innenvolumen, einen oberen Deckel und einen für den Kammerkörper schließenden unteren Deckel (6), im Betrieb sind die Substrate in einer zueinander beabstandeten Beziehung in das Innenvolumen des Kammerkörpers eingefügt und angeordnet, jeweilige Elektroden (40) sind zur Bereitstellung eines hochfrequenten elektromagnetischen Feld zwischen jeweiligen Paaren der Substrate (2) angeordnet, um eine dünne Materialschicht unter der Wirkung der Reaktionsgase auf den Oberflächen abzuscheiden; die zwischen den abzuscheidenden Oberflächen des Substrats (2) jeweiligen geformten Zwischenräume wirken als Strömungskanäle und bereitstellen eine laminare Strömung der Reaktionsgase zwischen zwei gegenüberliegenden Seiten des Kammerkörpers, jeweiligen gegenüberliegenden Elektroden der Elektroden (40) sind mit verschiedenen Anschlüsse (V) eines Hochfrequenzgenerator (G) verbunden und das geschlossene Innenvolumen der Kammer (1) ist mit einer Heizvorrichtung (F) vorgesehen, **dadurch gekennzeichnet, dass** der schließende untere Deckel (6) der Reaktionskammer (1) in eine vertikale Aufwärts- / AbwärtsRichtung geöffnet werden kann, und der Deckel eine Vielzahl von Tragrahmen (3) umfasst, die zum Umgeben und Halten der Substrate (2) entlang ihrer Unterseite und zwei Seitenkanten vorgesehen sind, die Tragrahmen (3) sind in einer beabstandeten Beziehung zueinander angeordnet, und die Tragrahmen (3) sind zum Umgeben und Halten der Unterseite und Seitenkanten der Substrate (2) und der Seitenkanten der Elektroden (40) jeweils entlang ihrer gesamten Länge mit einer periodischen Wiederholung von drei beabstandeten Ausnehmungen (4a, 4b) vorgesehen, wobei in jedem der beabstandeten Ausnehmungen (4a und 4b) Tripletts die zwei äußeren Ausnehmungen (4b) die Ränder eines zugehörigen Substrats (2) erhalten und die zentrale Ausnehmung (4a) die Ränder einer zugehörigen Elektrode (40) erhalt, sodass die Oberfläche der Substrate (2), die von der Elektrode beabstandet sind und der Elektrode (40) gegenüberliegen, die nicht-abgeschiedenen Oberflächen des Substrats sind, und die gegenüberliegenden Oberflächen der Substraten (2) die abgeschiedenen Oberflächen sind, und im Betrieb das Innenvolumen des Kammerkörpers im Wesentlichen durch den Abstand zwischen den Ausnehmungen (4a, 4b) der Rahmen (3) und durch die Abstände zwischen den Rahmen (4c) definiert ist, und der Abstand (4c) zwischen benachbarten Tragrahmen (3) die Breite der Gasströmungskanäle bestimmt, und der untere Deckel (6) zusammen mit den Tragrahmen (3) und den Substraten (2) in die Ausnehmungen (4b) zur Formung eines mechanisch integrierten Körpers eingeführt werden, der in Form eines Ladebehälters (5) in das Innenvolumen der Reaktionskammer (1) eingeladen bzw. befestigt und aus dem Innenvolumen der Reaktionskammer (1) entladen werden kann, und die Elektroden (40) an dem oberen Deckel befestigt und davon aufgehängt sind, und während der Ladung des Ladebehälters (5) in die Kammer die seitlichen und unteren Kanten der Elektroden mittels der zentralen Ausnehmungen (4a) der Tragrahmen (3) geführt und unterstützt sind.

2. Reaktionskammer (1) nach Anspruch 1, **dadurch gekennzeichnet, dass** die Tragrahmen (3) aus einem elektrisch isolierenden und wärmebeständigen Material hergestellt sind, und deren Außenteile mechanisch miteinander verbunden sind, sodass sie einen festen integrierten Körper bilden.

3. Reaktionskammer (1) nach Anspruch 1, **dadurch gekennzeichnet, dass** die zur Aufnahme der Substraten (2) geeigneten Ausnehmungen (4b) der Tragrahmen (3) eine geringere Tiefe als die zur Aufnahme der Elektroden (40) geeigneten Ausnehmungen (4a) haben.

4. Reaktionskammer (1) nach Anspruch 1, **dadurch gekennzeichnet, dass** die vertikalen Tragrahmen (3) durch jeweiligen Strukturen an jeder Seite miteinander verbunden sind, die mit Öffnungen (9) vorgesehen sind, die mit dem Gasströmungskanälen ausgerichtet sind, um das Einsetzen und Entfernen der Reaktionsgase von den Kanälen zu ermöglichen.

5. Reaktionskammer (1) nach Anspruch 1, **dadurch gekennzeichnet, dass** die Kammer eine rechteckige Form hat, wobei die Gasströmungskanäle sich an zwei gegenüberliegenden Seitenwände offen, die zu dem oberen Deckel und dem schließenden unteren Deckel (6) jeweils senkrecht sind, und an den Seitenwänden ein Gaseinlasskanal (50) und einem Gasaustrittskanal (51) gebildet sind.

6. Reaktionskammer (1) nach Anspruch 1, **dadurch gekennzeichnet, dass** die Tragrahmen (3), die die Substrate (2) von unten und entlang ihrer Seitenkanten halten, aus drei miteinander verbundenen Rahmenteilen (3) zusammengebaut sind.

7. Reaktionskammer (1) nach Anspruch 1, **dadurch gekennzeichnet, dass** eine elektrische Verbindung zwischen den Elektroden (40) und dem Hochfrequenzgenerator (G) während Laden und Entladen des Ladebehälters (5) gehalten werden kann.

8. Reaktionskammer (1) nach Anspruch 1, **dadurch gekennzeichnet, dass** jede der Elektroden (40) aus zwei voneinander beabstandeten Platten ausgebildet ist, die ein geschlossenes Innenvolumen definieren, wo Heizungselemente angeordnet sind, und die Elektroden (40) auch die Funktion eines Heizelements erfüllen.

## Revendications

1. Chambre de réaction (1) pour le dépôt d'une couche semiconductrice ou structure à couche sur une surface de chacun d'une pluralité de substrats (2) qui ont des formes rectangulaires de type à plaque et qui peuvent être insérés dans dite chambre de réaction (1), comprenant un corps de chambre avec un volume intérieur, un couvercle supérieur et un couvercle inférieur de fermeture (6) pour ledit corps de chambre, en opération les substrats sont insérés et disposés dans le volume intérieur du corps de chambre de manière espacée les uns des autres, électrodes (40) respectives sont disposées entre des paires des substrats (2) respectives pour fournir un champ électromagnétique à haute fréquence pour déposer une couche de matériau fine sur lesdites surfaces par moyens des gaz de réaction; les espaces respectifs formés entre lesdites surfaces de substrat (2) à déposer agissent comme canaux d'écoulement produisant un écoulement laminaire des gaz de réaction entre deux côtés opposes du corps de chambre, des électrodes opposées desdites électrodes (40) sont connectées à des connecteurs différents (V) d'un générateur à haute fréquence (G) et le volume intérieur fermé de la chambre (1) est fourni avec un appareil de chauffage (F), **caractérisée en ce que** le couvercle inférieur de fermeture (6) de la chambre de réaction (1) peut être ouvert en direction verticale haut/bas, et le couvercle comprend une pluralité de cadres de soutien (3) pour entourer et maintenir les substrats (2) au long de leur dessous et deux bords latéraux, lesdits cadres de soutien (3) sont disposés à une distance les uns des autres, et les cadres de soutien (3) sont chacun fourni avec une répétition périodique de trois évidements espacés (4a, 4b) fourni au long de leur entière longueur pour recevoir et maintenir lesdits dessous et bords latéraux des substrats (2) et pour les côtés des électrodes (40), dans lequel dans chacun des triplets desdits évidements espacés (4a et 4b) les deux évidements externes (4b) reçoivent les bords d'un substrat associé (2) et l'évidement central (4a) reçoit les bords d'une électrode (40) associée de telle manière que les surfaces desdits substrats (2) qui sont espacées de et font face à ladite électrode (40) sont les surfaces de substrat non déposées, et les surfaces opposées des substrats (2) sont lesdites surfaces déposées, et en opération ledit volume intérieur dudit corps de chambre est défini substantiellement par la distance d'espacement entre lesdits évidements (4a, 4b) des cadres (3) et les distances entre les cadres (4c), et la distance (4c) entre des cadres de soutien (3) adjacents détermine la largeur desdits canaux d'écoulement de gaz, et le couvercle inférieur (6) ensemble avec les cadres de soutien (3) et les substrats (2) sont insérés dans lesdits évidements (4b) pour former un corps mécaniquement intégré, ledit corps dans la forme d'un récipient de chargement (5) peut être chargé dans, fixé à et déchargé du volume intérieur de la chambre de réaction (1), et les électrodes (40) sont attachées à et sont suspendues du couvercle supérieur, et pendant le chargement du récipient de chargement (5) dans ladite chambre les bords externes et inférieurs des électrodes sont guidés et maintenus par les évidements centrales (4a) des cadres de soutien (3).

2. Chambre de réaction (1) selon la revendication 1, **caractérisée en ce que** les cadres de soutien (3) sont faites d'un matériau électriquement isolant et résistant à la chaleur, et leur éléments externes sont connectés mécaniquement l'uns avec les autres de telle manière à former un corps intégré et solide.

3. Chambre de réaction (1) selon la revendication 1, **caractérisée en ce que** les évidements (4b) des cadres de soutien (3) adaptés pour recevoir les substrats (2) ont des profondeurs plus petites que les évidements (4a) adaptés pour recevoir les électrodes (40).

4. Chambre de réaction (1) selon la revendication 1, **caractérisée en ce que** les cadres verticales de soutien (3) sont interconnectés par des structures respectives à chaque cotée qui sont fournies avec des ouvertures (9) alignées avec lesdits canaux d'écoulement de gaz pour permettre l'insertion et l'enlèvement des gaz de réaction par lesdits canaux.

5. Chambre de réaction (1) selon la revendication 1, **caractérisée en ce que** la chambre a une forme rectangulaire, dans laquelle les canaux d'écoulement de gaz s'ouvrent à deux flancs opposés qui sont chacun perpendiculaire au couvercle supérieur et le couvercle inférieur de fermeture (6), respectivement, et sur les flancs est formé un canal d'entrée de gaz (50) et un canal de sortie de gaz (51).

6. Chambre de réaction (1) selon la revendication 1, **caractérisée en ce que** les cadres de soutien (3) qui maintient les substrats (2) par le dessous et au long de leur bords latéraux sont assemblés à partir de trois parts de cadre de support interconnectés (3).

7. Chambre de réaction (1) selon la revendication 1, **caractérisée en ce que** la connexion électrique entre les électrodes (40) et le générateur (G) à haute fréquence peut être maintenue pendant le chargement et le déchargement du récipient de chargement (5).

8. Chambre de réaction (1) selon la revendication 1, **caractérisée en ce que** chacune des électrodes (40) est constituée par deux plaques espacées qui définissent un volume intérieur fermé dans lequel des éléments de chauffage sont disposés, et les électrodes (40) ont aussi la fonction d'élément de chauffage.
